Europäisches Patentamt

European Patent Office

Office européen des brevets

(19)

(11) Publication number: **0 029 717**
**B1**

(12) **EUROPEAN PATENT SPECIFICATION**

(45) Date of publication of patent specification: **11.07.84**

(21) Application number: **80304173.0**

(22) Date of filing: **20.11.80**

(51) Int. Cl.³: **G 11 C 11/40,**
**H 01 L 27/06,**
**H 01 L 27/10, H 01 L 21/74**

(54) Bipolar type static memory cell.

(30) Priority: **22.11.79 JP 151776/79**

(43) Date of publication of application:
**03.06.81 Bulletin 81/22**

(45) Publication of the grant of the patent:
**11.07.84 Bulletin 84/28**

(84) Designated Contracting States:
**DE FR GB NL**

(56) References cited:
**CH - A - 508 964**
**US - A - 3 909 807**

**PATENTS ABSTRACTS OF JAPAN, vol. 2, no.**
**79, 23rd June 1978, page 3224E78**
**NEUES AUS DER TECHNIK, no. 4, 1st July 1969,**
**page 2 Würzburg, DE. "Schutz von Transistoren"**
**IEEE JOURNAL OF SOLID-STATE CIRCUITS, vol.**
**SC-13, no. 5, October 1978, pages 651-656**
**New York, U.S.A. A. HOTTA et al.: "A high**
**speed low-power 4096 x 1 bit bipolar RAM"**

(73) Proprietor: **FUJITSU LIMITED**
**1015, Kamikodanaka Nakahara-ku**
**Kawasaki-shi Kanagawa 211 (JP)**

(72) Inventor: **Toyoda, Kazuhiro**
**39-1433, Sakuradai Midori-ku**
**Yokohama-shi Kanagawa 227 (JP)**
Inventor: **Ono, Chikai**
**322, Seki Tama-ku**
**Kawasaki-shi Kanagawa 214 (JP)**

(74) Representative: **Allman, Peter John et al,**
**Marks and Clerk Scottish Life House Bridge Street**
**Manchester M3 3DP (GB)**

Courier Press, Leamington Spa, England.

## Description

The present invention relates to a bipolar type static memory cell with a flip-flop circuit.

The bipolar type static memory cell usually has a flip-flop circuit consisting of load resistors and multiemitter transistors which are connected in a crossing manner. In such a flip-flop, a diode is often connected parallel with the load resistor to increase the operation speed. The diode, in many cases, will be an SBD (Schottky barrier diode) because it has a small carrier storage effect. However, although the Schottky barrier diode has a small carrier storage effect and is suited for high-speed operation, it has a small voltage drop in the forward direction, so that the data is stored relying upon the small voltage in the forward direction. Accordingly, the Schottky barrier diode is sensitive to noises and, therefore, has a small noise margin. In order to avoid the above inconvenience, therefore, an ordinary diode of the type of pn junction is often used. The diode of this type, however, has a large carrier storage effect, and causes the operation speed to be decreased as mentioned above.

The IEEE Journal of Solid-State Circuits, Vol. SC-13, No. 5, October 1978, pages 651—656, describes a high-speed low-power bipolar random access memory comprising a flip-flop circuit that is made up of two circuits connected in a crossing manner, each of said two circuits being composed of a load element and a transistor connected in series therewith, said bipolar type static memory cell comprising an N-type epitaxial layer grown on an $N^+$-type buried layer and providing a collector region of said transistor, a P-type layer formed in said N-type epitaxial layer and an $N^+$-type layer formed in said P-type layer being used as a base region and an emitter region of said transistor respectively.

This known memory cell has a load element formed as a PNP-transistor by a first P-type layer, a second P-type layer and a N-type epitaxially grown layer between the first and second P-type layers. The cell uses a load transistor with an ordinary pn-emitter-base junction with the result that it cannot operate at higher speeds and still obtain a sufficientl large noise margin.

Patent Abstracts of Japan, Vol. 2, No. 79, 23rd June 1978 page 3224 E78 (JP—A—5 343 485) discloses another bipolar memory cell similar to the one described above but in which the load element comprises a diode which is formed not only by an ordinary pn-junction but also by a $p^+n^+$-junction. A $P^+$-type layer is in direct contact with the P-type layer but extends to a greater depth to contact a buried $N^+$-type layer. Due to this specific emitter-base junction of the load diode a higher speed operation is possible.

An object of the present invention is to provide a bipolar type static memory cell having a high operation speed and and a good noise margin.

According to the present invention there is provided a bipolar type static memory cell in which a memory cell consists of a flip-flop circuit that is made up to two circuits connected in a crossing manner, each of said two circuits being composed of a load element and a transistor connected in series therewith, said bipolar type static memory cell comprising an $N$-type epitaxial layer grown on an $N^+$-type buried layer and providing a collector region of said transistor, a P-type layer formed in said N-type epitaxial layer and an $N^+$-type layer formed in said P-type layer being used as a base region and an emitter region of said transistor respectively, a P-type diffusion layer being formed in the surface of said epitaxial layer to contact said buried layer, whereby said load element is formed as a PNP lateral transistor by said P-type diffusion layer and said P-type layer and said N-type epitaxially grown layer between said P-type diffusion layer and said P-type layer, characterised in that said P-type layer includes first and second portions whereby only the second portion contacts said $N^+$-type buried layer.

Further features and advantages of the present invention will become apparent from the ensuing description with reference to the accompanying drawings to which, however, the scope of the invention is in no way limited.

Figure 1 is a circuit diagram of a conventional bipolar type static memory cell;

Figures 2, 3 and 4 are cross-sectional views illustrating the structure of the conventional memory cell of Figure 1;

Figure 5 is a circuit diagram of another conventional bipolar type static memory cell;

Figure 6 is a cross-sectional view illustrating a conventional memory cell structure providing the circuit of Figure 5;

Figure 7 is a cross-sectional view of a further bipolar type static memory cell structure which may be formed by conventional techniques to provide the circuit of Figure 5; and

Figures 8 and 9 are cross-sectional views illustrating embodiments of the present invention providing the circuit illustrated in Figure 5.

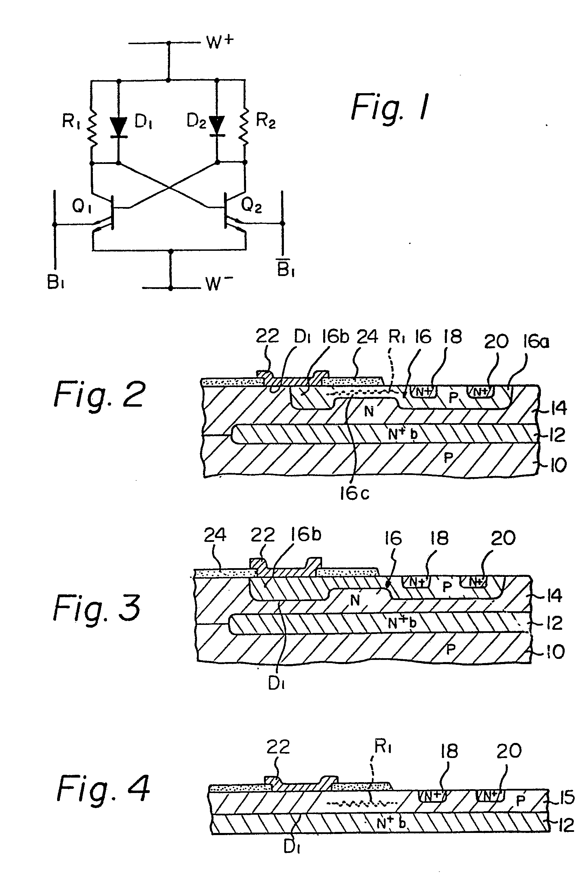

Referring to Figure 1, a static memory cell is shown which consists of a flip-flop having load resistors $R_1$, $R_2$ and multi-emitter transistors $Q_1$, $Q_2$, that are connected in a crossing manner. In order to increase the operation speed, however, diodes $D_1$, $D_2$ of polarities shown in Figure 1 are often connected in parallel with the load resistors $R_1$, $R_2$. Schottky barrier diodes (SBD) having a small carrier storage effect are often used as the above diodes $D_1$, $D_2$. Figure 2 illustrates the construction of a static memory cell of the above type in which reference numeral 10 denotes a P-type silicon semiconductor substrate, 12 denotes an $N^+$-type buried layer, 14 denotes an N-type epitaxially grown layer, 16 denotes a P-type diffusion layer, 18 and 20 denote N$^+$-type diffusion layers, 22 denotes an aluminium electrode, and 24 denotes an insulation film composed of silicon dioxide, or the like. The N$^+$-type layers 18, 20, in this case, serve as two emitter regions of the multi-emitter transistor $Q_1$, a portion 16a in the P-type layer 16 serves as a base region, and the N-type layer 14 serves as a collector region, thereby constituting the transistor $Q_1$. A portion 16c having a narrow cross-sectional area in the P-type layer 16 serves as the resistor $R_1$, and an electrode 22 which connects to a portion 16b having a wide cross-sectional area, serves as a terminal that is connected to a word line W$^+$. The electrode 22 is Schottky barrier-contacted to the N-type layer 14 to form an SBD $D_1$ between the two. Although not diagrammed, the transistor $Q_2$ is also constructed in the same way. Symbole $\overline{W}$ shown in Figure 1 denotes a hold line, and $B_1$ and $\overline{B_1}$ shown in Figure 1 denote a pair of bit lines.

The Schottky barrier diode has a small electric charge storage effect and is suited for high-speed operation. It, however, has a small voltage drop in the forward direction, and must store the data relying upon the small voltage in the forward direction. Accordingly, the Schottky barrier diode is sensitive to noise and has a small noise margin. For the purpose of removing the above inconvenience, ordinary pn junction diodes are often used such as diodes $D_1$, $D_2$ as illustrated in Figure 3. The cell of Figure 3 is different from the cell of Figure 2 in that portion 16b of the P-type layer 16 completely covers the lower portion of the electrode 22, and that the diode $D_1$ (the same holds true for the diode $D_2$) is constituted by the P-type layer 16b beneath the electrode 22 and by the N-type layer 14. A cell of this type exhibits an increased noise margin. However, since the cathode of the diode consists of an epitaxial layer 14 having a low impurity concentration, carriers are naturally stored in increased amounts in the N-type layer 14 to decrease the operation speed.

Therefore, it has been contrived to use pn$^+$-junction diodes that are constructed as shown in Figure 4. In this case, a P-type epitaxial layer 15 is laminated on the N$^+$-type buried layer, and N$^+$-type diffusion layers 18 and 20 are formed in the P-type epitaxial layer 15, whereby the layer 18, 20 are utilized as emitter regions, the layer 15 is utilized as a base region, and the N$^+$-type layer 12 is utilized as a collector region. The diode $D_1$ (the same holds true for the diode $D_2$) is formed by the layers 15, 12 beneath the electrode 22. In the pn$^+$-junction diode having a high impurity concentration in the N$^+$-type layer 12, the holes which are injected into the N$^+$-type layer 12 undergo quick recombination and are extinguished and, hence, carriers are stored in small amounts. Further, the junction-type diode shown in Figure 4 has a voltage in the forward direction which is greater than that of the Schottky barrier diode, and has a large noise margin. Technically, however, it is difficult to form the epitaxially grown layer maintaining a small thickness. Consequently, the effective base width of the transistor tends to be increased. When the base has a large thickness, the transistor exhibits a small $f_T$ as is widely known, which makes it difficult to realize high-speed operations.

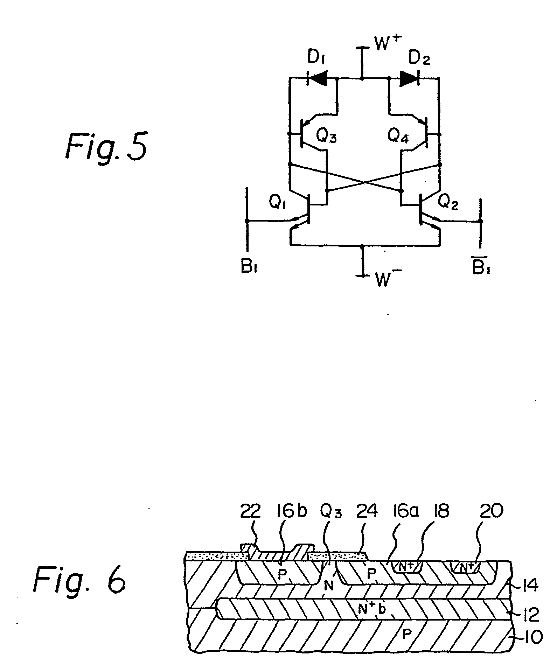

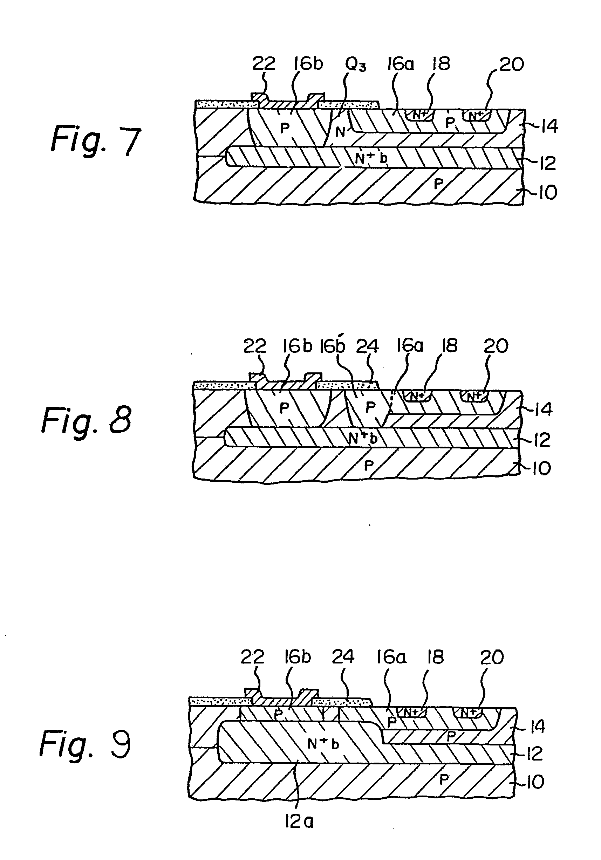

There has also been proposed a bipolar type static memory cell in which the load resistors $R_1$ and $R_2$ are replaced by PNP transistors $Q_3$ and $Q_4$ as illustrated in Figure 5. The memory cell of Figure 5 has heretofore been constructed as shown in Figure 6, in which a transistor $Q_3$ (the same holds true for a transistor $Q_4$) is constructed in the form of a PNP layer transistor by P-type diffusion layers 16a, 16b by the N-type epitaxial layer 14 located therebetween. Further, the parasitic diodes $D_1$, $D_2$ connected parallel with the transistors $Q_3$, $Q_4$, i.e. connected prallel with the load resistors, are constructed between the P-type diffusion layer 16b and the N-type layer 14. The diodes $D_1$, $D_2$ in Figure 6 can be regarded as portions of the emitter-base junctions of the PNP transistors $Q_3$, $Q_4$, and need not be shown in the equivalent circuit. They, however, are indicated from the standpoint of illustrating the charge storage effect. In this case, like the case of Figure 3, holes injected into the N-type layer 14 are stored therein to decrease the operation speed. Furthermore, it may also be considered as conventional for the diode $D_1$ (and the diode $D_2$) to be constituted by the P-type diffusion layer 16b and the N$^+$-type embedded layer 12 as shown in Figure 7, in order to reduce the electric charge storage effect and to obtain a sufficiently large noise margin.

Figure 8 illustrates a first embodiment of the invention in which a first portion of the P-type layer 16a is formed as in Figure 7 so as not to contact the buried layer 12 and a second portion 16b' is formed to a greater depth so as to contact the buried layer 12. In this case, the positions of the emitter and collector of the PNP transistor are self-aligned, and little variance is introduced into the characterisics.

Figure 9 illustrates a further embodiment in which a portion 12a of the buried layer 12 is formed at a lesser depth below the surface of lyaer 14 than the rest of the buried layer 12 so as to contact the layer 16b and a portion 16b' of the layer 16a. The memory cell of this embodiment, of course, produces effects that are the same as those of Figures 7 and 8. An emitter of the PNP transistor is formed by the P-type diffusion layer 16b and a collector of the same is formed by the P-type diffusion layer 16b'. Both the P-type diffusion layers 16b, 16b' reach the buried layer 12 in Figure 9.

According to the present invention as illustrated in detail in the foregoing, there is provided a static memory cell which is simply constructed, which operates at a high speed, and which gives an increased noise margin.

**Claims**

1. A bipolar type static memory cell in which a memory cell consists of a flip-flop circuit that is made up of two circuits connected in a crossing manner, each of said two circuits being composed of a load element and a transistor connected in series therewith, said bipolar type static memory cell comprising an N-type epitaxial layer (14) grown on an N+-type buried layer (12) and providing a collector region of said transistor, a P-type layer (16a) formed in said N-type epitaxial layer (14) and an N+-type layer (18, 20) formed in said P-type layer being used as a base region and an emitter region of said transistor respectively, a P-type diffusion layer (16b) being formed in the surface of said epitaxial layer (14) to contact said buried layer (12), whereby said load element is formed as a PNP laterl transistor by said P-type diffusion layer (16b) and said P-type layer (16a) and said N-type epitaxially grown layer (14) between said P-type diffusion layer (16b) and said P-type layer (16a), characterised in that said P-type layer (16a) includes first and second portions whereby only the second portion (16b') contacts said N+-type buried layer (12).

2. A bipolar type static memory cell according to claim 1, characterised in that said P-type diffusion layer (16b) and said second portion (16b') of the P-type layer extend to a greater depth from the surface of the N-type epitaxial layer (14) than the first portion of said P-type layer.

3. A bipolar type static memory cell according to claim 1, characterised in that said N+-type buried layer (12) comprises a first portion which is at a first depth beneath the surface of the N-type epitaxially grown layer (14) and a second portion which is at a lesser depth than the first portion, and P-type diffusion layer (16b) and the second portion (16b') of the P-type layer (16a) contacting the second portion of the N+-type buried layer (12).

**Patentansprüche**

1. Statische bipolare Speicherzelle, bei welcher eine Speicherzelle aus einer Flipflop-Schaltung besteht, die aus zwei Schaltungen hergestellt ist, die kreuzweise miteinander verbunden sind, wobei jede der beiden Schaltungen aus einem Lastelement und einem mit diesem in Reihe liegenden Transistor aufgebaut ist, welche statische bipolare Speicherzelle umfaßt: eine epitaktische N-Schicht (14), die auf einer vergrabenen N+-Schicht (12) aufgewachsen ist und einen Kollektorbereich für den genannten Transistor bildet, eine P-Schicht (16a), die in der genannten epitaktischen N-Schicht (14) ausgebildet ist, und eine N+-Schicht (18, 20), welche auf der genannten P-Schicht ausgebildet ist, die als ein Basisbereich bzw. ein Emitterbereich des genannten Transistors verwendet wird, eine P-Diffusionsschicht (16b), die in der Oberfläche der genannten epitaktischen Schicht (14) gebildet ist, um die vergrabene Schicht (12) zu kontaktieren, wodurch das genannten Lastelement als ein PNP-Lateraltransistor durch die genannte P-Diffusionsschicht (16b), die genannte P-Schicht (16a) und die genannte epitaktisch aufgewachsene N-Schicht (14) zwischen der genannten P-Diffusionsschicht (16b) und der genannten P-Schicht (16a) gebildet wird, dadurch gekennzeichnet, daß die genannte P-Schicht (16a) einen ersten und einen zweiten Abschnitt aufweist, wobei lediglich der zweite Abschnitt (16b') die vergrabene N+-Schicht (12) kontaktiert.

2. Statische bipolare Speicherzelle nach Anspruch 1, dadurch gekennzeichnet, daß die P-Diffusionsschicht (16b) und der zweite Abschnitt (16b') der P-Schicht sich von der Oberfläche der epitaktischen N-Schicht (14) in eine größere Tiefe als der erste Abschnitt der P-Schicht erstrecken.

3. Statische bipolare Speicherzelle nach Anspruch 1, dadurch gekennzeichnet, daß die vergrabene N+-Schicht (12) einen ersten Abschnitt umfaßt, welcher sich in einer ersten Tiefe unterhalb der Oberfläche der epitaktisch gewachsenen N-Schicht (14) befindet, und einen zweiten Abschnitt, welcher sich in einer geringeren Tiefe als der erste Abschnitt befindet, und die P-Diffusionsschicht (16b) und der zweite Abschnitt (16b') der P-Schicht (16a) den zweiten Abschnitt der vergrabenen N+-Schicht (12) Kontaktieren.

**Revendications**

1. Cellule à mémoire statique du type bipolaire dans laquelle une cellule à mémoire consiste en un circuit à bascule constitué de deux circuits connectés d'une manière croisée, chacun des deux circuits étant constitué d'un élément de charge et d'un transistor connectés en série, la cellule à mémoire statique du type bipolaire comprenant une couche épitaxiale de type N (14) déposée par croissance sur une couche ensevelie de type N+ (12) et fournissant une région de collecteur du transistor, une couche de type P (16a) formée dans la couche épitaxiale de type N (14) et une couche de type N+ (18, 20) formée dans la couche de type P étant respectivement utilisées comme région de base et comme région d'émetteur du transistor, une couche de diffusion de type P (16b) étant formée à la surface de la couche épitaxiale (14) pour être mise en contact avec la couche ensevelie (12), l'élément de charge étant ainsi formé comme un transistor latéral PNP par la couche de diffusion de type P (16b) et la couche de type P (16a) et la couche à croissance épitaxiale de type N (14) formée entre la couche de diffusion de type P (16b) et la couche de type P (16a), caractérisée en ce que la couche de type P (16a) comprend des première et seconde parties par lesquelles seule la seconde partie (16b′) est en contact avec le couche ensevelie de type N⁺ (12).

2. Cellule à mémoire statique du type bipolaire selon la revendication 1, caractérisée en ce que la couche de diffusion de type P (16b) et la seconde partie (16b′) de la couche de type P s'étendent sur une profondeur plus grande à partir de la surface de la couche épitaxiale de type N (14) que la première partie de la couche de type P.

3. Cellule à mémoire statique du type bipolaire selon la revendication 1, caractérisée en ce que la couche ensevelie de type N⁺ (12) comprend une première partie qui est à une première profondeur au-dessous de la surface de la couche à croissance épitaxiale de type N (14) et une seconde partie qui est à une profondeur moins grande que la première partie, la couche de diffusion de type P (16b) et la seconde partie (16b′) de la couche de type P (16a) étant en contact avec la seconde partie de la couche ensevelie de type N⁺ (12).

Fig. 1

Fig. 2

Fig. 3

Fig. 4

*Fig. 5*

*Fig. 6*

*Fig. 7*

*Fig. 8*

*Fig. 9*